# EUROPEAN PATENT APPLICATION

(11) **EP 2 388 575 A1**
(43) Date of publication of application: **23.11.2011**
(21) Application number: 11166954.5
(22) Date of filing: 20.05.2011
(51) Int. Cl.: G01N 23/22, H01J 37/20

(54) **Sample holder, inspection apparatus and inspection method**

(30) Priority: 20.05.2010 JP 2010116093
(71) Applicant: JEOL Ltd., Akishima, Tokyo 196-8558 (JP)
(72) Inventor: Nishiyama, Hidetoshi, Tokyo 196-8558 (JP); Saotome, Nobuo, Tokyo 196-8558 (JP); Suga, Mitsuo, Tokyo 196-8558 (JP)
(74) Representative: Cross, Rupert Edward Blount

(57) **Abstract**

A sample holder (40) is offered which permits a liquid sample (20) to be observed or inspected well. Also, an inspection apparatus (29) and an inspection method using the sample holder (40) are offered. The sample holder (40) has a film (32) including a first surface (32a) and a second surface (32b). The liquid sample (20) is held on the first surface (32a). The film (32) is made of two or more layers. A space inside the apparatus which is in contact with the second surface (32b) is placed in a reduced-pressure ambient. A primary beam (7) (such as an electron beam) irradiation device (2) is installed in the reduced-pressure space. A primary beam (7) produced from the primary beam irradiation device (2) is directed at the liquid sample (20) via the film (32). Consequently, the sample (20) can be observed or inspected while maintaining the sample at the atmospheric pressure. During observation or inspection, if the film (20) is damaged, the space in the apparatus (29) is restored to atmospheric pressure at the time when breakage of one of the layers of the film (32) is detected. Thus, contamination of the inside of the apparatus can be prevented.

## Description

### 1. Field of the Invention

The present invention relates to sample holder, inspection apparatus, and inspection method permitting a liquid sample or a sample consisting of cultured biological cells to be observed or inspected well.

### 2. Description of the Related Art

We living organisms are multicellular animals and develop diseases if information cannot be transmitted normally among cells or if viruses or chemical substances cling to cells. For this reason, in the fields of molecular biology and pharmaceutics, research is conducted by peeling off cells from a living organism, cultivating the cells on a laboratory dish, giving a reagent (such as a chemical substance or medicine) to the cells, and observing the resulting reaction on the cellular level. In the past, optical microscopes have been used for such observation. Frequently, important portions to be observed are very tiny regions of less than 0.1 µm that are impossible to observe with an optical microscope. For example, diseases arising from inability to exchange substances normally among biological cells include hypertension, diabetes insipidus, arrhythmia, myopathy, diabetes, and deprementia. Exchange of substances among cells is performed by ion channels having sizes of about 10 nm and existing in cell membranes. Because it is difficult to observe such ion channels with optical microscopes, there has been a demand for a technique enabling observation using a scanning electron microscope (SEM) having high resolution.

However, a sample to be inspected with an inspection apparatus incorporating SEMcapabilities is normallyplaced in a sample chamber whose internal pressure has been reduced by vacuum pumping. The sample placed in the sample chamber, which in turn is placed in a reduced-pressure ambient in this way, is irradiated with an electron beam (charged particle beam). Secondary signals such as secondary electrons or backscattered electrons produced from the sample in response to the irradiation are detected. Where cells are exposed to a reduced-pressure ambient, moisture in the cells evaporates, destroying the structure of the cells. In order to prevent this, a long pretreatment including anhydration and drying is normally required. Consequently, it has been impossible, of course, to observe reactions of cells within a solution to a reagent.

Accordingly, when an inspection is performed under the condition where the sample contains moisture, it is necessary to prevent the sample from being exposed to the reduced-pressure ambient; otherwise, moisture would evaporate from the sample. One conceivable method of inspecting a sample using SEM without exposing the sample to a reduced-pressure ambient in this way consists of preparing a sample holder (sample capsule that may or may not be hermetically sealed) whose opening (aperture) has been sealed off by a film, placing the sample in the holder, and installing the holder in an SEM sample chamber that is placed in the reduced-pressure ambient.

The inside of the sample capsule (sample holder) in which the sample is placed is not evacuated. The film that covers the opening formed in the sample capsule can withstand the pressure difference between the reduced-pressure ambient inside the SEM sample chamber and the ambient (e.g., atmospheric-pressure ambient) of the inside of the sample capsule that is not pumped down. Furthermore, the film permits an electron beam to pass therethrough (see patent document 1).

When a sample is inspected, a culture medium (culture solution) is first put into a sample capsule together with cells. The cells are cultivated on the film. Then, the sample capsule is placed into an SEM sample chamber that is in a reduced-pressure ambient. An electron beam is directed at the sample placed within the sample capsule from outside the capsule via the film formed on the capsule. Backscattered electrons are produced from the irradiated sample. The backscattered electrons pass through the film formed on the capsule and are detected by a backscattered electron detector mounted in the SEM sample chamber. Consequently, an SEM image is derived.

However, with this technique, the sample is sealed in the closed space and so it has been impossible to administer a reagent from the outside. Furthermore, the amount of the culture medium put into the sample capsule is about 15 µℓ. Therefore, as the culture medium evaporates, the salinity concentration rises, making it difficult to culture cells. Where the cells should be observed or inspected in vivo, there arises a problem. This problem can be solved by increasing the size of the sample capsule to increase the internal capacity. However, if the film is destroyed either by stimulation induced by an electron beam or by a mechanical stimulus, a new problem is created. That is, the inside of the apparatus is contaminated with a large amount of culture medium.

An example of a method of obtaining an SEM image by preparing a film withstanding the pressure difference between vacuum and atmospheric pressure, irradiating a sample with an electron beam via the film, and detecting backscattered electrons produced from the sample in this way is described also in non-patent document 1 (especially, Chapter 1: Introduction).

Examples in which two films of the structure described above are placed opposite to each other with a sample interposed between the films and in which an image is acquired by a transmission electron microscope are described in patent documents 2 and 3. Especially, patent document 2 also states a case in which an SEM image of the sample interposed between such films is acquired.

Patent document 4 discloses a technique that has solved the problems with the aforementioned sample capsule. In this technique, an inverted SEM column is used. The front end of the column from which electrons exit and its vicinities are sealed with a film, thus completely isolating the vacuum from the atmosphere. The film acts also to hold the sample and is open on its topside.

Therefore, it is possible that the amount of culture medium is increased and cells are cultured over a long term. An SEM image of the sample placed on the film and at atmospheric pressure can be obtained by irradiating the sample with an electron beam via the film and detecting backscattered electrons. In addition, a structure having a dishlike body portion on which a film is placed is under discussion (see patent document 5).

However, there is the problem that if the film is destroyed by electron beam irradiation, the sample intrudes into the SEM column, making the SEM unusable. According to this technique, a partition valve is mounted between the film and the SEM column as a means for preventing contamination of the SEM column when the film is destroyed. However, if the partition valve is used immediately after destruction of the film, it takes time to actuate the valve and, consequently, it has been impossible to completely prevent contamination.

### Prior Art References

Patent Documents
[Patent document 1] JP-T-2004-515049
[Patent document 2] JP-A-47-24961
[Patent document 3] JP-A-6-318445
[Patent document 4] JP-A-2007-292702
[Patent document 5] JP-A-2008-210765
[Non-patent document 1] "Atmospheric scanning electron microscopy", Green, Evan Drake Harriman, Ph.D., Stanford University, 1993

The resolution of an optical microscope is not high enough to observe very tiny regions of biological cells. Observations using SEM are necessary. In order to observe cells by SEM while maintaining the liquid state, a sample containing cells is sealed in a sample capsule. The sample is imaged by irradiating the sample with an electron beam via a film formed on the sample capsule.

However, the sample capsule is a narrow closed space. Therefore, there is the problem that it has been impossible to administer a reagent from the outside. Furthermore, the internal capacity of the sample capsule is small. Consequently, when moisture evaporates and the salinity concentration rises, it is difficult to culture cells for a longtime. Hence, there are problems in observing cells for a long time.

The techniques of patent documents 4 and 5 have successfully solved this problem but suffers from the problem that the inside of the apparatus is contaminated with the sample by complete destruction of the film.

### SUMMARY OF THE INVENTION

In view of the foregoing, the present invention has been made. It would desirable to provide sample holder, inspection apparatus, and inspection method capable of certainly preventing contamination of the inside of an apparatus by preventing complete destruction of a film holding a sample.

A first sample holder according to the present invention has a sample-holding surface that is opened to permit access from the outside. At least a part of the sample-holding surface is formed by a film having first and second surfaces. The sample-holding surface is formed by the first surface of the film on which a sample is held. A primary beam for imaging or inspection of the sample can be directed at the sample from the second surface side of the film via the film. The film is made of a laminate structure including at least two layers.

A second sample holder according to the invention has a closed sample-holding surface at least a part of which is formed by a film having first and second surfaces. The sample-holding surface is formed by the first surface of the film on which a sample is held. A primary beam for imaging or inspection of the sample can be directed at the sample from the second surface side of the film via the film. The film is made of a laminate structure including at least two layers.

Advantageous effects can be obtained by fabricating the layers of the film successively with an intervening interval of a given time if the layers are fabricated under exactly the same conditions. Furthermore, the layers of the film can be formed under different conditions.

A sample inspection apparatus according to the present invention permits imaging or inspection of a sample through the use of any of the above-described sample holders, and has holder placement means on which the sample holder is placed, primary beam irradiation means for irradiating the sample with a primary beam via the film formed on the sample holder, and signal detection means for detecting a secondary signal emanating from the sample in response to the primary beam irradiation.

A sample inspection method according to the present invention starts with placing a sample on the sample-holding surface of any of the above-described sample holders. The sample is irradiated with a primary beam via the film. A secondary signal emanating from the sample in response to the primary beam irradiation is detected.

In the aforementioned apparatus and method, the primary beam is a charged particle beam or an electron beam. The secondary beam is one type of secondary electrons, backscattered electrons, absorption current, cathodoluminescent light, and X-rays.

The present invention provides a sample holder, an inspection apparatus using the sample holder, and an inspection method. The sample holder has a sample-holding surface that is opened to permit access from the outside. At least a part of the sample-holding surface is formed by a film having a first surface. The sample-holding surface is formed by the first surface of the film. A sample is held on the sample-holding surface. The sample can be irradiated with a primary beam via the film to enable imaging or inspection of the sample. The film is made of a laminate structure including at least two layers. The sample holder may be a closed capsule that is inaccessible from the outside.

The conventional apparatus has the problem that, if a sample-holding film is completely destroyed by electron beam irradiation, the sample diffuses into the apparatus, contaminating the inside.

In the present invention, the sample-holding film is made of a laminate structure including at least two layers. If it has been confirmed that one layer of the sample-holding film has been damaged or destroyed by electron beam irradiation, use of the apparatus is stopped in response to the confirmation. One form of this use is to increase the pressure inside the apparatus back to the atmospheric pressure. In this way, contamination of the inside of the apparatus can be prevented.

Other features and advantages of the present invention will become apparent from the following more detailed description, taken in conjunction with the accompanying drawings, which illustrate, by way of example, the principles of the invention.

### BRIEF DESCRIPTION OF THE DRAWINGS

Fig. 1 is a schematic block diagram of an embodiment of the sample inspection apparatus of the present invention;
Fig. 2 is a cross-sectional view of a sample holder according to the invention, showing its structure;
Fig. 3 is a schematic perspective view of a frame-like member forming the sample holder according to the invention;
Fig. 4 shows sequential cross sections illustrating a method by which the frame-like member constituting the sample holder according to the invention is fabricated;
Fig. 5 is a schematic block diagram of an embodiment of the sample inspection apparatus according to the present invention; and
Fig. 6 is a schematic block diagram of another embodiment of the sample inspection apparatus of the present invention.

### DETAILED DESCRIPTION OF THE INVENTION

Sample holder, inspection apparatus, and inspection method according to the present invention are hereinafter described with reference to the drawings.

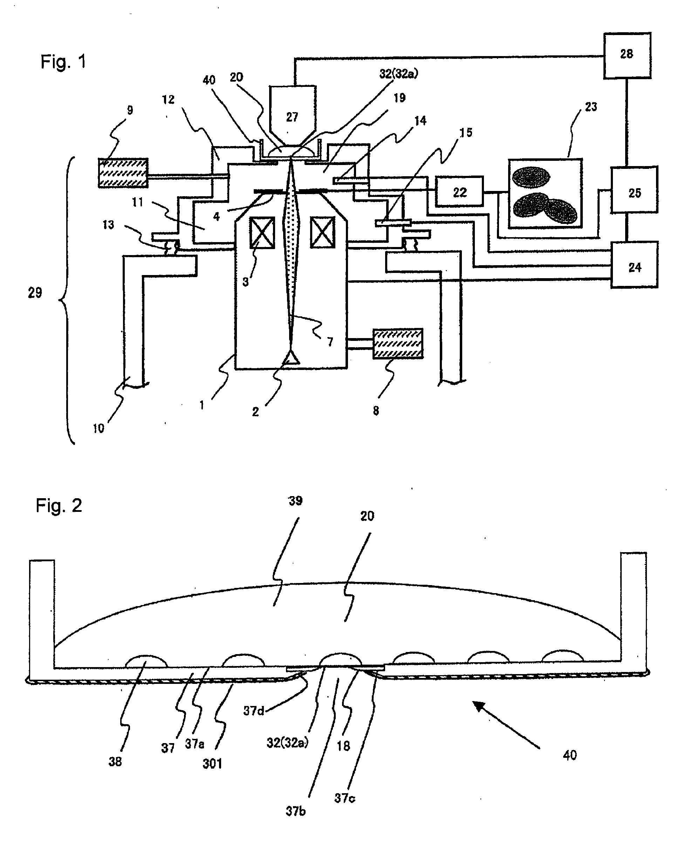

Fig. 1 is a schematic block diagram showing a first embodiment of the sample inspection apparatus according to the present invention. The apparatus consists chiefly of an optical microscope 27 and an electron beam apparatus section (SEM) 29 located under a sample holder 40.

In Fig. 1, an electron gun 2 forming an electron source is disposed in an electron optical column 1 constituting primary beam irradiation means. The gun 2 emits an accelerated electron beam (charged particle beam) 7 that is a primary beam. The beam 7 is focused by condenser lenses (objective lens) 3.

The focused electron beam 7 is directed at a liquid sample 20 via a sample-holding film 32 (described later) formed on the sample holder 40. The sample 20 is held on the sample holder 40. In the present embodiment, the liquid sample 20 includes biological cells and a culture medium.

The front-end side of the electron optical column 1 is connected with a vacuum chamber 11. The electron gun 2 is mounted in the base side of the electron optical column 1. The base side of the column 1 is located under the vacuum chamber 11. Because of this configuration, the electron beam 7 released from the electron gun 2 travels upward through the optical column 1, passes through the space inside the vacuum chamber 11 and through the sample-holding film 32, and reaches the liquid sample 20.

During the irradiation, the electron beam 7 is deflected by deflection means (not shown). Thus, the beam 7 scans the liquid sample 20. At this time, a specimen contained in the liquid sample 20 is also scanned with the beam 7.

The electron optical column 1 forms the primary beam irradiation means in this way. In the present embodiment, the electron optical column is of the inverted type. A backscattered electron detector 4 is mounted at the front-end side of the column 1 within the vacuum chamber 11. The detector 4 detects backscattered electrons produced when the specimen included in the liquid sample 20 is irradiated with the electron beam 7. For example, a semiconductor detector using a PN junction or a scintillator detector using a YAG crystal is used as the backscattered electron detector 4. The output signal from the detector 4 is sent to an image formation device 22 disposed outside the vacuum chamber 11. The image formation device 22 forms image data based on the output signal from the detector 4. The image data corresponds to an SEM image, and is sent to a display device 23. The display device 23 displays an image based on the image data sent in. The displayed image forms an SEM image. If necessary, the image data formed by the image formation device 22 is sent to a computer 25. The computer 25 image-processes the image data and makes decisions based on the result of the image processing.

The inside of the electron optical column 1 is pumped down to a desired pressure by vacuum pumping means 8. The inside of the vacuum chamber 11 is evacuated to a desired pressure by vacuum pumping means 9. The vacuum chamber 11 is placed over a pedestal 10 via a vibration-proofing device 13.

A sample holder placement portion 12 is formed on top of the vacuum chamber 11 and provided with a hole to permit the electron beam 7 to be directed at the sample-holding film 32. The sample holder 40 is placed on the placement portion 12 via an O-ring (not shown). Consequently, the sample holder 40 is withdrawably supported in the vacuum chamber 11.

The sample holder 40 is constructed as shown in Fig. 2 and sized to have a diameter of 35 mm and a height of 13 mm. The holder can hold 2 mℓ of culture medium, and permits cells to be cultured over a long term. The holder 40 is composed of a dishlike body portion 37 made of plastic or glass and a film holder (frame-like member) 18 on which the sample-holding film 32 is formed. The film 32 transmits the electron beam 7. A recessed portion is located inside the body portion 37. The bottom surface of the recessed portion forms a sample-holding surface 37a that is open. Consequently, a medicine can be administered from the outside.

The sample-holding surface 37a of the body portion 37 is (centrally in the example of Fig. 2) provided with a through-hole 37b. A step portion 37c is formed around the hole 37b on the side of the sample-holding surface 37a. The film holder 18 is disposed on the step portion 37c and has the sample-holding film 32. The sample-holding film 32 has a first surface 32a that forms the sample-holding surface 37a. The first surface 32a of the film 32 is substantially flush with the sample-holding surface 37a of the body portion 37. Consequently, at least a part of the sample-holding surface 37a of the sample holder 40 is formed by the sample-holding film 32.

Tapering portions 37d are formed on the side of the hole 37b on the opposite side of the sample-holding surface 37a. The tapering portions 37d are spread apart toward the surface on the opposite side of the sample-holding surface 37a. The spread angle is set to 90° to 120°.

A region of the lower surface of the sample holder 40 might be exposed to a vacuum ambient and become irradiated with the electron beam 7. A conductive film 301 is formed on this region to prevent charging of the sample holder 40 when it is irradiated with the beam 7. The conductive film 301 is in contact with the film holder 18. Electric charge accumulated by being irradiated by the electron beam 7 can be dissipated away to the liquid sample 20 via the film holder 18 made of silicon. The presence of the conductive film 301 reduces the charging of the lower surface of the sample holder 40 and can prevent displacement of the orbit of the beam 7 (that would normally be produced when the liquid sample 20 is illuminated with the beam 7) and distortion and illumination spots in the SEM image that would be normally produced by displacement of the orbit of backscattered electrons. Accumulation of electric charge can be prevented with certainty by connecting a grounding line to the liquid sample 20 or electrically connecting the conductive film 301 with the sample holder placement portion 12. The conductive film 301 can be formed, for example, by vapor-depositing aluminum, gold, or indium tin oxide or applying silver paste.

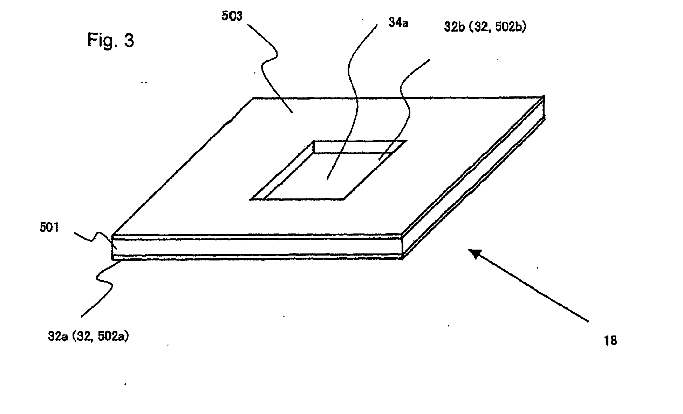

The structure of the film holder 18 is shown in Fig. 3. The sample-holding film 32 is formed on a silicon substrate 501. The first surface 32a of the sample-holding film 32 (lower surface as viewed in Fig. 3; upper surface as viewed in Fig. 2) is exposed. The liquid sample 20 containing liquid such as a culture medium and specimen cells is placed on the first surface (sample-holding surface) 32a of the sample-holding film 32. Since the first surface 32a is under atmospheric pressure, evaporation of moisture from the liquid sample 20 can be suppressed to a minimum.

The silicon substrate 501 is centrally provided with an opening 34a (upper surface in Fig. 3; lower surface in Figs. 1 and 2) covered with the sample-holding film 32. A central portion of the second surface 32b of the sample-holding film 32 is exposed to the inside ambient of the vacuum chamber 11 through the opening 34a.

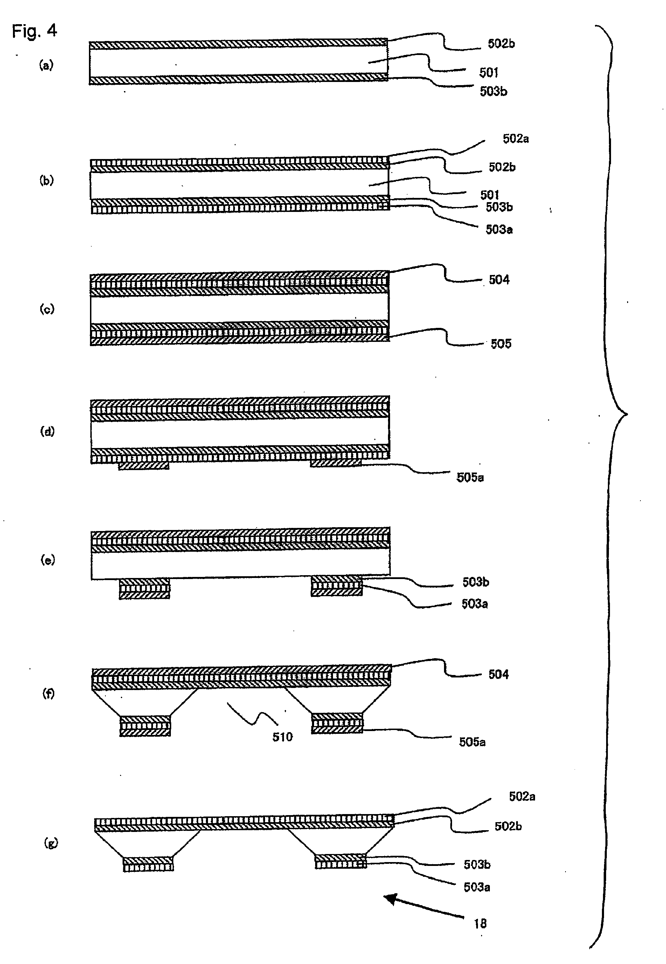

A method of creating the film holder 18 is next described by referring to Fig. 4. First, as shown Fig. 4(a), silicon nitride layers (silicon nitride films 502b and 503b) are formed on the silicon substrate 501 using CVD (chemical vapor deposition). A typical thickness of the layers 502b and 503b is 80 nm. Then, formation of the films is interrupted by stopping the supply of the stock gases, and the films are allowed to stand for a given time. Then, the stock gases are supplied under the same conditions to form separate silicon layers (silicon nitride films) 502a and 503a (Fig. 4(b)). A typical thickness of these layers 502a and 503a is 20 nm. As a consequence, the layers 502a and 503a are stacked on the layers 502b and 503b, respectively.

The two layers 502a and 502b are of the same composition. Similarly, the layers 503a and 503b are of the same composition. An interval is placed between the process step of forming the former layers and the process steps of forming the latter layers. Differences in film quality and positional deviations of atomic array are present as boundaries between the layers. Especially, with respect to differences in film quality, when the second layers (502a and 503a) are formed on the first layers (502b and 503b), it is known that the portions of the second layers which are formed at the beginning of the film growth are different in film quality from the topmost portions of the first layers (desirably stably formed portions) because the former portions are formed immediately after (resupply) of the stock gases. As a consequence, the sample-holding film 32 made of a two-layered structure is formed. The laminate structure of the sample-holding film 32 may contain more than two layers.

The first layers (502b and 503b) and the subsequently formed, secondlayers (502a and 503a) may be built under different conditions. For example, in order to form a silicon nitride film, SiH₂Cl₂ gas and NH₃ gas are used. During the film growth, the ratio (flow rate ratio, concentration ratio, or the like) of the supplied gases may be varied. The difference (absolute value) in elemental ratio x between the layers of silicon nitride SiNₓ is most preferably 0.2 or more.

A laminate structure that can be used as the sample-holding film 32 is not restricted to layers of silicon nitride. Other examples include layers of silicon oxide SiOₓ (x is an elemental ratio), layers of boron nitride, layers of polymer, layers of polyethylene, layers of polyimide, layers of polypropylene, and layers of carbon. In these cases, the laminate structure can be formed by stacking similar or dissimilar layers on top of each other. One conceivable example of the laminate structure consisting of dissimilar layers is a laminate structure consisting of a layer of silicon nitride SiNₓ and a layer of silicon oxide SiOₓ.

In the laminate structure of the similar or dissimilar layers, the thicknesses of the layers can be set by adjusting the film growth time. Preferably, the total thickness of the laminate structure of the sample-holding film 32 (i.e., the thickness of the sample-holding film 32) is 50 to 200 nm. The electron beam and backscattered electrons can sufficiently pass through the laminate structure having a thickness in this range. Furthermore, a sufficient resistance to the differential pressure can be assured.

Where the laminate structure is made of two layers, the thickness of any of the layer forming the first surface (sample-holding surface) of the sample-holding film 32 and the layer forming the second surface of the sample-holding film 32 can be thinned to 10-20 nm. In this case, the thinned layer of the two-layered structure is considerably thinner than the other layer.

Where the laminate structure constituting the sample-holding film 32 consists of three or more layers, the thicknesses of the layers forming the first and/or second layers of the sample-holding film 32 can be set to 10-20 nm.

In the above examples, the first and second surfaces are the exposed surfaces of the sample-holding film 32.

After forming the laminate structure of the layers or films as described above, resist, 504 and 505, is applied on the silicon nitride film, 502a and 503a, respectively (Fig. 4(c)). The layer of resist 505 is patterned photolithographically to leave behind resist layer portions 505a (Fig. 4(d)). Using the resist pattern as a mask, the silicon nitride films 503a and 503b are processed by dry etching, and silicon nitride film portions 503a and 503b in a pattern are left behind (Fig. 4(e)). Using the pattern as a mask, the silicon substrate 501 is wet-etched with KOH to form an opening 510 (Fig. 4(f)). The resist layer portions 504 and 505a are ashed away (Fig. 4(g)).

In the filmholder 18 fabricated in this way, the sample-holding film 32 is formed by the laminate structure of the silicon nitride layers (silicon nitride films) 502a and 502b. In this laminate structure, the surface of the silicon nitride layer 502a facing away from the surface in contact with the silicon nitride layer 502b forms the sample-holding surface (first surface) of the sample holder 40. Conversely, the surface of the silicon nitride film 502b in the laminate structure which faces away from the surface in contact with the silicon nitride film 502a can constitute the sample-holding surface (first surface) of the sample holder 40.

The sample-holding film 32 transmits the electron beam 7 but does not transmit gas or liquid. Moreover, it is necessary that the film be capable of withstanding a pressure difference of at least 1 atmosphere across the opposite surfaces of the film. As the thickness of the sample-holding film32 is reduced, scattering of the electron beam 7 is reduced and, therefore, the resolution is improved but the film is more easily damaged. As the thickness is increased, scattering of the electron beam 7 increases, resulting in decreased resolution. However, the film is less likely to be damaged. The thickness of the film (i.e., the sum of the thickness of the silicon nitride layer 502a and the thickness of the silicon nitride layer 502b) is preferably 50 nm to 200 nm. Especially, the thickness of the layer (i.e., the layer forming the second surface facing away from the sample-holding surface of the sample-holding film 32) exposed to the reduced-pressure ambient (vacuum) is preferably 10 to 20 nm.

The film holder 18 is firmly attached to the step portion 37c over the hole 37b formed in the body portion 37 forming the sample holder 40. Thus, the sample holder 40 is fabricated (Fig. 2). To attach the holder 18 to the step portion firmly, bonding using an epoxy-based or silicone-based adhesive or fusion making use of heat, ultrasonic waves, or laser light can be used. Consequently, the film holder 18 is firmly held in a position corresponding to the hole 37b in the sample-holding surface 37a of the body portion 37.

In the present embodiment, the body portion 37 and film holder 18 are combined to fabricate the sample holder 40. The sample-holding film 32 may be directly firmly bonded to the body portion 37. The body portion 37 and the sample-holding film 32 may be fabricated integrally. Furthermore, cell adhesion molecules (described later) acting as molecules for bonding the sample may be applied to the sample-holding surface 37a including the first surface 32a of the sample-holding film 32.

In this way, in the present embodiment, the vacuum is isolated from the atmosphere by the sample-holding film 32. The electron beam is directed at the liquid sample 20 via the film 32. Therefore, there is the possibility that the sample-holding film 32 will be completely destroyed by the electron beam 7. If so, the liquid sample 20 would enter into the vacuum chamber 11, contaminating the electron optical column 1.

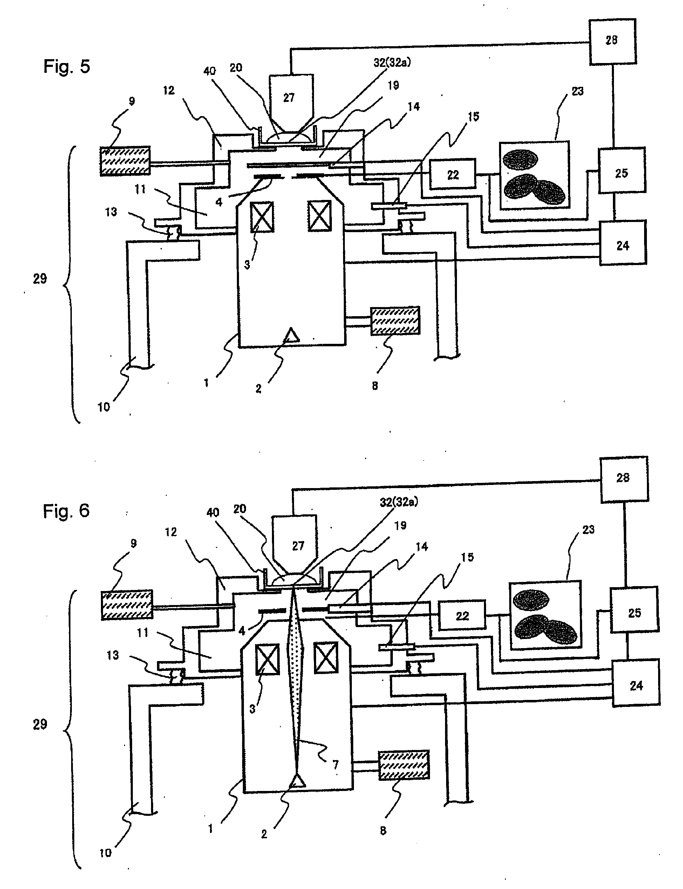

To prevent this, a vacuum gauge 15 for detecting the pressure inside the vacuum chamber 11 is mounted in the vacuum chamber 11. A shutter 14 is mounted between the front end of the electron optical column 1 and the sample-holding film 32. The shutter 14 is in open state in Fig. 1. When the film 32 is completely destroyed and a given pressure rise is detected by the vacuum gauge 15, the shutter 14 is automatically moved and closed as shown in Fig. 5.

For example, when the sample-holding film 32 is completely destroyed and the liquid sample 20 flows into the vacuum chamber 11 to thereby make the pressure inside the vacuum chamber higher than 100 Pa, the shutter 14 is moved as shown in Fig. 5. Simultaneously, the insides of the vacuum chamber 11 and column 1 are restored to the atmospheric pressure. This prevents inflow of the liquid sample 20.

In consequence, the liquid sample 20 entering the vacuum chamber 11 can be received and stopped by the shutter 14. Hence, contamination of the electron optical column 1 and backscattered electron detector 4 is prevented. If the shutter is fitted with a receiver dish for receiving the liquid sample, then it is possible to cope with inflow of a large amount of liquid sample. The shutter 14 partitions the vacuum chamber 11 into two vertically separated spaces partially rather than completely. Therefore, the shutter is simple in structure and can be operated at high speed. In the present embodiment, the vacuum gauge 15 detects a rise in the pressure. After a lapse of 0.1 second, the shutter can be set into operation to bring the shutter from the state of Fig. 1 to the state of Fig. 5.

However, it is difficult to completely prevent the liquid sample 20 from intruding into the apparatus during a short interval between when the sample-holding film 32 is completely destroyed and when the shutter 14 is closed. Hence, the apparatus is contaminated. If the liquid sample 20 has the nature of corroding metals, the apparatus will be seriously damaged.

In the present invention, a symptom of complete destruction of the sample-holding film 32 is caught in advance to solve the problem. The method of solution is based on the fact that the sample-holding film 32 is made of a laminate structure including two or more layers.

For example, where the sample-holding film 32 is made of a two-layered structure (silicon nitride layers 502a and 502b), if the film 32 is damaged by electron beam irradiation via the vacuum ambient, one of the two layers is destroyed earlier. Especially, where one layer is thinned (e.g., when the total thickness of the two-layered structure is 100 nm and the thickness of one layer (silicon nitride layer 502a) is 20 nm), the thinner layer is destroyed earlier. The destruction can be automatically recognized by a steep variation in a brightness histogram created by data about a scanned image taken by the SEM 29. The variation is recognized by the computer 25. The vacuum chamber 11 is instantly restored to the atmospheric pressure. Thus, complete destruction of the sample-holding film 32 can be prevented in advance.

Referring to Fig. 6, there is shown another apparatus which is similar to the apparatus described so far except that the backscattered electron detector 4 is formed at the front end of the shutter 14. When the shutter 14 is open, the detector 4 is located just above the electron optical column 1 as shown in Fig. 7. Under this condition, the efficiency at which backscattered electrons are detected is maximized. This configuration shortens the working distance between the column 1 and the liquid sample 20, improving the resolution of the SEM image. In this case, destruction of the sample-holding film 32 will lead to contamination of the detector. In the present invention, a symptom of destruction of the film 32 is detected. This makes it very easy to service the apparatus.

The electron beam apparatus section 29 equipped with the
electron optical column 1 and the vacuum chamber 11 also includes the shutter 14 and vacuum gauge 15, and is under control of an electron beam controller 24. The optical microscope 27 for observing the sample is placed on the sample holder placement portion 12, which in turn is under control of a controller 28.

The optical axis of the optical microscope 27 is coincident with the optical axis of the electron beam 7. Alternatively, the center of field of view of the optical microscope 27 is coincident with the center of field of view of the SEM image. A region observed by the optical microscope can be made substantially coincident with the SEM image. The field of view of the SEM image and the field of view of the optical microscope 27 can be adjusted by moving the sample holder placement portion 12 on which the sample holder 40 is placed by means of a moving mechanism (not shown).

The inspection apparatus according to the present invention has the electron beam apparatus section 29, optical microscope 27, electron beam controller 24, controller 28, image formation device 22, and display device 23. These portions are connected with the computer 25. Information can be exchanged between these portions.

An inspection method according to the present invention is next described. First, as shown in Fig. 2, the cells 38 forming a specimen to be inspected are cultured within the culture medium 39 using the sample holder 40. Since the amount of culture medium can be set to 2 mℓ, the cells can be cultured for a long time. Depending on biological cells, if cell adhesion molecules (molecules for bonding of the specimen) are applied to the sample-holding surface 37a of the sample holder 40 (especially, the first surface (sample-holding surface) 32a of the sample-holding film 32 observed with an electron beam), cultivation is facilitated. The cell adhesion molecules cause cells arranged for cultivation and cells proliferated by cultivation to be adsorbed onto the sample-holding surface. Examples of the cell adhesion molecules include collagen, fibronectin, vitronectin, cadherin, integrin, claudins, desmogleins, neuroligin, neurexin, selectin, laminins, and poly-L-lysine.

After the cells are cultured within the sample holder 40, the sample holder 40 is placed on the holder placement portion 12. At this time, the shutter 14 is closed and in the state of Fig. 5. Subsequently, the insides of the vacuum chamber 11 and electron optical column 1 are evacuated to desired degrees of vacuum using the vacuum pumping means 8 and 9. For example, the pressure inside of the vacuum chamber 11 is set to less than 1 Pa. The pressure inside the electron optical column 1 (especially, around the electron gun 2) is set to about 10⁻⁴ to 10⁻⁵ Pa in a case where the electron gun is of the thermionic type. Where the gun is of the Schottky emission type or field emission type, the pressure is set to about 10⁻⁷ to 10⁻⁹ Pa.

Then, the cells 38 are checked with the optical microscope 27. Because the sample holder 40 is open, it is easy to administer a medicine. Under this condition, the medicine is administered to the cells 38. The resulting reaction can be observed with the optical microscope 27.

An SEM image can be obtained using the electron beam apparatus section 29 in order to obtain a high-resolution image. To prevent light from entering the backscattered electron detector 4 via the sample-holding film 32, the optical microscope 27 is stopped from being illuminated with light, and other extraneous light is blocked in a manner not illustrated. This blocking acts also to protect against radiation produced when the electron beam 7 hits the film holder 18 and liquid sample 20. As shown in Fig. 1, the electron beam 7 is directed from the electron optical column 1 at the liquid sample 20 including the cells 38, and the sample is scanned with the beam 7. The beam 7 passes through the film 32 of the sample holder 40 and hits the cells 38. Backscattered electrons produced from the cells 38 in response to the irradiation are detected by the backscattered electron detector 4.

Since the tapering portions 37d are formed around the hole 37b of the body portion 37 constituting the sample holder 40, collision of backscattered electrons with the inner surface of the hole 37b can be suppressed to a minimum. Thus, the backscattered electrons are suppressed from being blocked. The backscattered electrons can be detected by the backscattered electron detector 4 efficiently.

The output signal from the detector 4 is sent to the image formation device 22, which in turn forms image data based on the output signal from the detector 4. Based on the image data, the display device 23 displays an SEM image.

In the foregoing, backscattered electrons are used to form an image. Backscattered electrons produce a signal intensity proportional to the atomic number. Therefore, where the sample is almost totally made of substances of low atomic numbers such as a biological specimen, the image contrast is very low, and it is difficult to improve the resolution. Accordingly, a heavy metal such as gold may be adsorbed onto portions of the cells 38 to be noticed in their behavior. In particular, gold is adsorbed onto the portions (antigen) via an antibody by causing the antigen tagged with gold particles having the nature of being adsorbed on the portions (antigen) to be sprayed against the cells by making use of an antigen-antibody reaction. Furthermore, a fluorescent dye or quantum dots (e.g., nanoparticles of Si or particles of CdSe coated with ZnS and having sizes of 10 to 20 nm) that emit light when irradiated with an electron beam may be previously adsorbed onto certain portions of the cells 38, and the emitted light may be observed with an optical microscope.

In the above embodiment, normally used gold particles have particle diameters of 10 to 30 nm. However, the adsorptive force between the antibody and gold particles is weak, and gold particles of 10 to 30 nm may not be attached. In this case, very small gold particles (nanogold particles) having particle diameters of the order of nanometers are first attached to the antibody. Under this condition, the gold particles are too small and it is difficult to observe them by SEM. Silver is adsorbed around the gold particles by making use of a silver sensitizer. This makes it easier to detect them by SEM.

In this way, use of the present invention makes it possible to perform SEM imaging of a submerged specimen using the sample-holding film 32. Since the amount of cultivation medium can be set to 2 mℓ, long-term cultivation of cells is enabled. Because the open sample chamber is used, access to the sample from the outside is permitted. Hence, it is easy to administer a medicine to the cells. The reaction or state can be observed with the optical microscope 27 and electron beam apparatus section (SEM) 29. An oil immersion type can be used as the optical microscope. High-resolution optical microscope images can be derived.

In the present apparatus, if the sample-holding film 32 is destroyed, the liquid sample 20 will flow either into the vacuum chamber 11 or into the electron optical column 1, contaminating the apparatus. In the present embodiment, however, a symptom of destruction of the film 32 can be detected. That is, the sample-holding film 32 is made of at least two layers. One of the layers is first destroyed. The manner in which the layer is destroyed can be easily observed with the SEM 29 or optical microscope 27. The operation of the apparatus can be stopped instantly.

If the sample-holding film 32 should be destroyed (i.e., the liquid sample 20 would enter the vacuum chamber 11), contamination of the column 1 can be suppressed to a minimum by the operation of the shutter 14 and restoring the insides of the vacuum chamber 11 and column 1 to the atmospheric pressure.

In the above embodiment, an electron beam is used as a primary beam. If the sample-holding film 32 shows sufficient shock resistance and intensity against impingement of other charged particle beam (such as a helium ion beam), the invention can be applied to a case where the other charged particle beam is used.

In the above embodiments, backscattered electrons are used as a secondary beam. Information about the cells 38 can also be obtained by detecting other form of information such as secondary electrons, X-rays, cathodoluminescent light, and electric current absorbed into the cells 38 forming a specimen.

In the present embodiment, it is assumed that the sample holder takes a dishlike form and has the sample-holding film whose sample-holding surface is accessible from the outside. The sample holder is not restricted to this structure. One modification of this sample holder is a closed, capsule-type sample holder having a spatially isolated interior. A part of the holder is formed by the sample-holding film 32. This modified sample holder produces similar advantageous effects.

In this way, a first sample holder according to the present invention has a sample-holding surface that is opened to permit access from the outside. At least a part of the sample-holding surface of the holder is formed by a film having first and second surfaces. The sample-holding surface is formed by the first surface of the film on which a sample is held. A primary beam for imaging or inspection of the sample can be directed at the sample from the second surface side of the film via the film. The film is made of a laminate structure including at least two layers. This sample holder may be referred to as the accessible open type.

A second sample holder according to the invention has a closed sample-holding surface at least a part of which is formed by a sample-holding film having first and second surfaces. The sample-holding surface is formed by the first surface of the film on which a sample is held. A primary beam for imaging or inspection of the sample can be directed at the sample from the second surface side of the film via the film. The film is made of a laminate structure including at least two layers. This sample holder may be referred to as the capsule type.

In the above-described types of sample holder, the layers of the sample-holding film are fabricated successively under the same conditions but with an intervening interval of a given time. The film can be made of a laminate structure of silicon nitride SiNₓ, where x is an elemental ratio.

The layers forming the film may be fabricated under different conditions to build the film. The film is made of a laminate structure of silicon nitride SiNₓ, where x is an elemental ratio. The difference (absolute value) of x between different types of SiNₓ forming the respective layers may be set to 0.2 or more. Additionally, the film may be a laminate structure of a layer of SiNₓ and a layer of silicon oxide SiOₓ.

In the above examples of the film, at least one layer is thinner than the other layer or layers. Preferably, the thickness of the film is in the range of 50 to 200 nm. In each layer forming the film, the thickness of at least one of the layers forming the exposed surfaces of the film is preferably 10 to 20 nm. As one example, the layers constituting the film in each example of film described above are fabricated by chemical vapor deposition.

A sample inspection apparatus according to the present invention permits imaging or inspection of a sample through the use of any of the above-described sample holders, and has holder placement means on which the sample holder is placed, primary beam irradiation means for irradiating the sample with a primary beam via the film on the sample holder, and signal detection means for detecting a secondary signal emanating from the sample in response to the primary beam irradiation.

A sample inspection method according to the present invention starts with placing a sample on the sample-holding surface of any one of the above-described sample holders. The sample is irradiated with a primary beam via the film. A secondary signal emanating from the sample in response to the primary beam irradiation is detected.

The sample inspection apparatus has a vacuum chamber. An ambient in contact with the surface of the film facing away from the sample-holding surface is made a vacuum ambient by the vacuum chamber.

The primary beam is a charged particle beam or an electron beam. The secondary signal is any one type of secondary electrons, backscattered electrons, absorption current, cathodoluminescent light, and X-rays. The sample-holding surface of the film of the sample holder is the upper surface of the film, while the opposite surface is the lower surface of the film. There is also provided optical imaging means for obtaining an optical image of a sample held on the sample-holding surface of the film of the sample holder.

In the present invention, the sample-holding film is made of a laminate structure including at least two layers as described previously. Therefore, it is assured that contamination of the inside of the apparatus is prevented by automatically checking destruction of one layer due to damage caused by electron beam irradiation and stopping the operation of the apparatus in response to the check (including increase in the pressure inside the apparatus (such as restoration to atmospheric pressure)).

## Claims

1. A sample holder comprising:
a sample-holding surface, at least apart of the sample-holding surface being formed by a film having first and second surfaces, the sample-holding surface being formed by the first surface of the film on which a sample is held, the film being made of a laminate structure including at least two layers, whereby a primary beam for imaging or inspection of the sample can be directed at the sample from a side of the second surface of the film via the film.

2. A sample holder according to claim 1 wherein the sample-holding surface is opened to permit access from the outside.

3. A sample holder according to claim 1 wherein the sample-holding surface is a closed sample-holding surface.

4. A sample holder as set forth in any one of claims 1 to 3, wherein said film has been formed by fabricating the layers of the film successively under the same conditions but with an intervening interval of a given time.

5. A sample holder as set forth in any one of claims 1 to 4, wherein said film is made of a laminate structure of silicon nitride SiNₓ, where x is an elemental ratio.

6. A sample holder as set forth in any one of claims 1 to 3, wherein the layers constituting said filmhave been fabricated under different conditions.

7. A sample holder as set forth in claim 6, wherein said film is made of a laminate structure of silicon nitride SiNₓ, where x is an elemental ratio, and wherein a difference (in absolute value) in x included in SiNₓ between the layers is 0.2 or more.

8. A sample holder as set forth in claim 6, wherein said film is made of a laminate structure including a layer of SiNₓ and a layer of silicon oxide SiOₓ.

9. A sample holder as set forth in any one of claims 1 to 8, wherein at least one of the layers constituting said film is thinner than the other layer or layers.

10. A sample holder as set forth in any one of claims 1 to 9, wherein said film has a thickness of 50 to 200 nm.

11. A sample holder as set forth in claim 10, wherein at least one of the layers constituting said film and forming exposed surfaces of the film has a thickness of 10 to 20 nm.

12. A sample holder as set forth in any one of claims 1 to 11, wherein the layers constituting said film have been fabricated by chemical vapor deposition.

13. A sample inspection apparatus for observing or inspecting a sample using a sample holder as set forth in any one of claims 1 to 12, said sample inspection apparatus comprising:
holder support means on which the sample holder is placed;
primary beam irradiation means for irradiating the sample placed on said film of the sample holder with a primary beam via the film; and
signal detection means for detecting a secondary signal emanating from the sample in response to the primary beam irradiation.

14. A sample inspection apparatus as set forth in claim 13, further comprising a vacuum chamber by which an ambient in contact with the surface of said film facing away from the sample-holding surface is made a vacuum ambient.

15. A sample inspection apparatus as set forth in any one of claims 13 and 14, wherein said primary beam is a charged particle beam or an electron beam, and wherein said secondary signal is any one type of secondary electrons, backscattered electrons, absorption current, cathodoluminescent light, and X-rays.

16. A sample inspection apparatus as set forth in any one of claims 13 and 15, wherein the sample-holding surface of the film of said sample holder is an upper surface of the film, while an opposite surface is a lower surface of the film.

17. A sample inspection apparatus as set forth in any one of claims 13 to 16, further comprising optical imaging means for obtaining an optical image of the sample held on the sample-holding surface of the film of said sample holder.

18. A sample inspection method comprising the steps of:
placing a sample on the sample-holding surface of the sample holder as set forth in any one of claims 1 to 12;
irradiating the sample with a primary beam via said film;
and
detecting a secondary signal produced from the sample in response to the primary beam irradiation.

19. A sample inspection method as set forth in claim 18, wherein during the primary beam irradiation, a surface of the film of said sample holder facing away from the sample-holding surface is in contact with a vacuum ambient, and wherein the primary beam is directed at the sample through the vacuum ambient.

20. A sample inspection method as set forth in any one of claims 18 and 19, wherein said primary beam is a charged particle beam or an electron beam, and wherein said secondary beam is any one type of secondary electrons, backscattered electrons, absorption current, cathodoluminescent light, and X-rays.

21. A sample inspection method as set forth in any one of claims 18 and 20, wherein the sample-holding surface of the film of said sample holder is an upper surface of the film, while an opposite surface is a lower surface of the film.

22. A sample inspection method as set forth in any one of claims 18 and 21, further comprising the step of obtaining an optical image of the sample disposed on the sample-holding surface of the film of said sample holder.
